# EUROPEAN PATENT SPECIFICATION

(11) **EP 3 151 645 B1**
(45) Date of publication and mention of the grant of the patent: **17.04.2019**
(21) Application number: 16190434.7
(22) Date of filing: 23.09.2016
(51) Int. Cl.: H05K 7/20

(54) **DOUBLE-SIDED HEAT EXCHANGER FOR FLUID-COOLED ELECTRONICS WITH A FLAT COPLANER SERIES-WISE COOLANT FLOW PATH**
DOPPELSEITIGER WÄRMETAUSCHER FÜR FLÜSSIGKEITSGEKÜHLTE ELEKTRONIKA MIT EINEM FLACHEN, KOPLANAREN SERIENBEWUSSTEN KÜHLMITTELDURCHFLUSSWEG
ÉCHANGEUR DE CHALEUR À DOUBLE FACE POUR L'ÉLECTRONIQUE REFROIDI AYANT UN TRAJET D'ÉCOULEMENT DE RÉFRIGÉRANT DE SÉRIE COPLANAIRE PLAT

(30) Priority: 30.09.2015 US 201562234746 P; 04.08.2016 US 201615228008
(43) Date of publication of application: 05.04.2017
(73) Proprietor: Delphi Technologies IP Limited, St. Michael (BB)
(72) Inventor: LO, Brian, San Francisco, California 94121 (US); EBENHART, Mark A., Kokomo, Indiana 46902 (US)
(74) Representative: Delphi France SAS

(56) References cited:
- WO-A1-2014/027514
- WO-A1-2015/037824
- US-A1- 2008 117 602
- US-A1- 2012 250 253

## Description

### TECHNICAL FIELD

This disclosure generally relates to a fluid-cooled electronics assembly configured to provide a flat coplanar series-wise coolant flow path.

### BACKGROUND OF INVENTION

It is known that high-power electronic devices such as solid-state power switches need to have heat removed for reliable operation. In electric-vehicle applications the ambient temperature may require circulated liquid coolant to remove enough heat to maintain reliability. Automotive applications are highly cost sensitive and high packaging density is desired, so the configuration of the electronics packaging and coolant management is critical. Patent documents WO2015/037824 describes a heat exchanger for cooling an electrical element and US 2012/250253 describes a cooling arrangement for a semiconductor module.

### SUMMARY OF THE INVENTION

Described herein is a flat-coplanar-heat-exchanger suitable for use in an electric-vehicle that provides for double-sided series-wise of fluid coolant to remove heat from both sides of electrical components.

In accordance with one embodiment, a fluid-cooled electronics assembly for high-power electronics is provided. The assembly includes an arrangement of electronic components that defines an upper-side of the arrangement, and a lower-side of the arrangement opposite the upper-side. An upper-chamber is thermally coupled to the upper-side. The upper-chamber is configured to guide flowing-coolant from an upper-inlet to an upper-outlet to remove heat from the upper-side. A lower-chamber is thermally coupled to the lower-side. The lower-chamber is configured to guide flowing-coolant from a lower-inlet to a lower-outlet to remove heat from the lower-side. The upper-chamber and the lower-chamber are further configured to cooperatively define a transfer-path that fluidicly couples the lower-outlet to the upper-inlet such that the flowing-coolant flows series-wise from the lower-chamber into the upper-chamber. The upper-chamber and the lower-chamber are further configured to cooperatively define a manifold-connection operable to couple the assembly to a manifold-outlet and a manifold-inlet of a coolant-manifold such that the flowing-coolant flows through the assembly. The assembly also includes a fitting configured to define an inlet-port of the assembly that directs the flowing-coolant from the manifold-outlet to the lower-inlet, and an outlet-port that directs the flowing-coolant from the upper-outlet to the manifold-inlet. The inlet-port and the outlet-port are characterized as adjacent and side-by-side ports that are segregated from each other by a wall-section.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a fluid cooled electronics assembly in accordance with one embodiment;
Fig. 2 is a sectional view of the assembly of Fig. 1 in accordance with one embodiment;
Fig. 3 is an exploded view of the assembly of Fig. 1 in accordance with one embodiment;
Fig. 4 is a fitting used in the assembly of Fig. 1 in accordance with one embodiment; and
Fig. 5 is an alternative fluid cooled electronics assembly with an alternative fitting in accordance with one embodiment.

### DETAILED DESCRIPTION

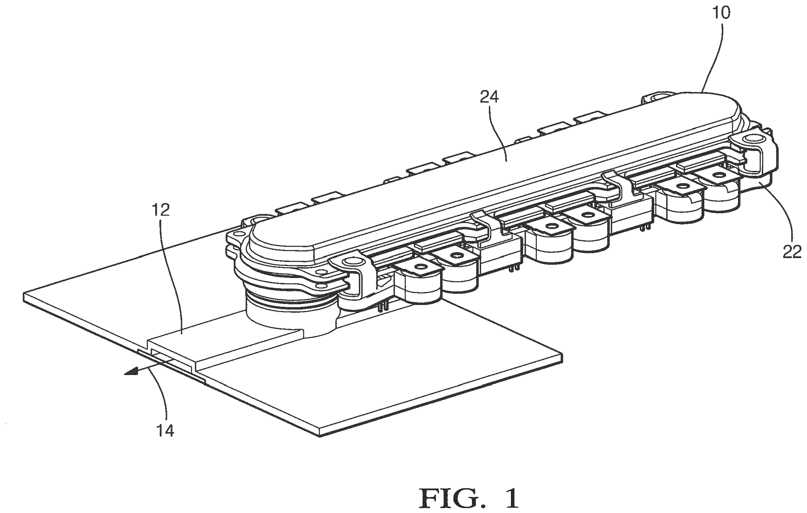

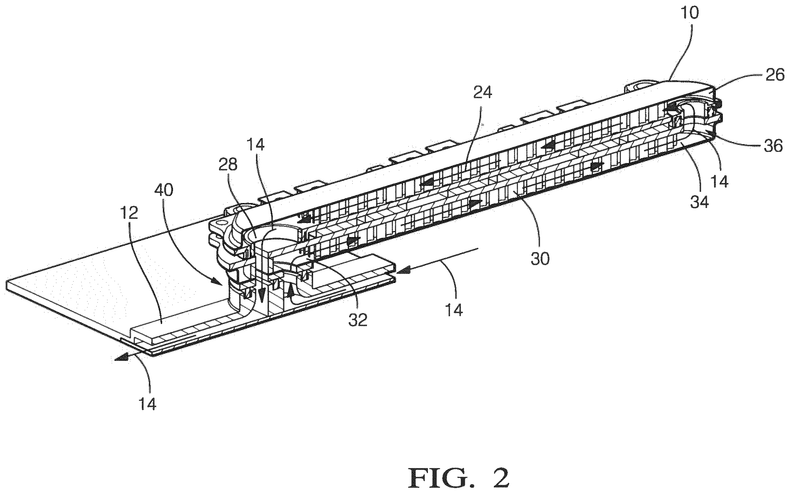

Figs. 1 and 2 illustrate a non-limiting example of a fluid-cooled electronics assembly, hereafter referred to as the assembly 10. In general, the assembly 10 is particularly useful for cooling high-power electronics such as an inverter used to control the flow of electrical energy from a bank of batteries (not shown) to an electric-motor used to propel an electric-vehicle (not shown). The assembly 10 is fluidicly coupled to a coolant-manifold 12 in a manner effective so flowing-coolant 14 can be directed through the assembly 10, the details of which are explained later.

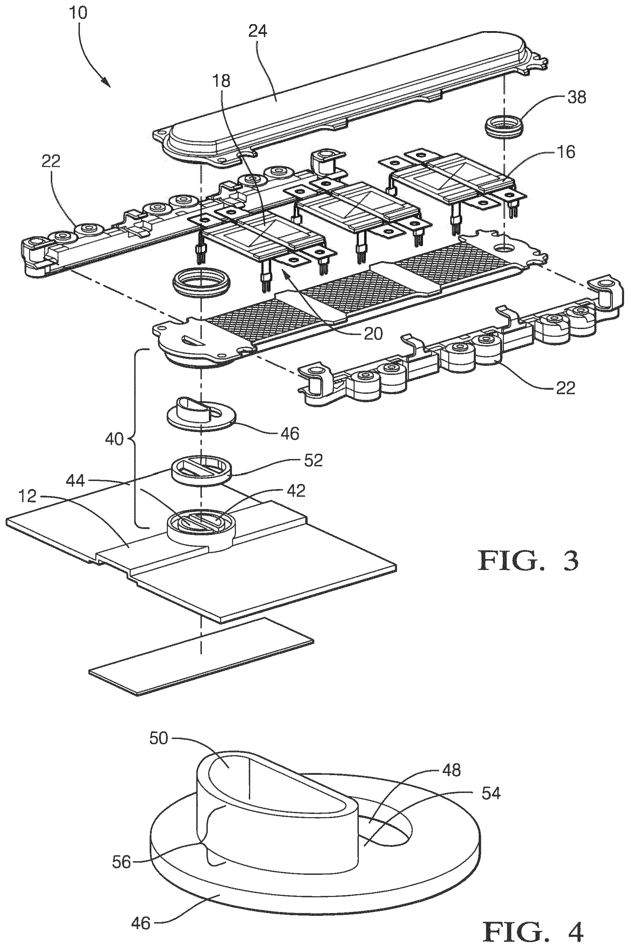

Fig. 3 further illustrates details of the assembly 10 which includes an arrangement 16 of electronic components that defines an upper-side 18 of the arrangement 16 and a lower-side 20 of the arrangement 16 opposite the upper-side 18. That is, the electronic components that form the arrangement 16 are configured so heat can be removed from both opposing sides of the electronic components. It is contemplated that electrical connections to the electronic components may be made on the surfaces of the electronic components that define the upper-side 18 and/or the lower-side 20, and that other electrical connections may be made at the perimeters of the electronic components by, for example, electrical-contacts 22.

To provide double-sided cooling for the electronic components, the assembly 10 includes an upper-chamber 24 (i.e. upper heat-sink) thermally coupled to the upper-side 18, and a lower-chamber 30 (i.e. lower heat-sink) thermally coupled to the lower-side 20. The upper-chamber 24 is configured to guide the flowing-coolant 14 from an upper-inlet 26 to an upper-outlet 28 to remove heat from the upper-side 18. Similarly, the lower-chamber 30 is configured to guide flowing-coolant from a lower-inlet 32 to a lower-outlet 34 to remove heat from the lower-side 20. The upper-chamber 24 and the lower-chamber 30 may be formed of a polymeric compound, or may be formed from sheet-metal that is stamped, formed, and friction-welded to form the respective chambers.

As used herein, the use of relative terms such as 'upper' and 'lower', and the designations of particular features as 'inlet' and 'outlet' are only for the purpose of simplifying the explanation of the assembly 10, and not to be construed as any particular limitation. For example, it is contemplated that the direction of the flowing-coolant 14 could be reversed so that the flowing-coolant passes through the upper-chamber 24 before passing through the lower-chamber 30, which may result in exchanging each instance of the terms 'inlet' and 'outlet'.

The upper-chamber 24 and the lower-chamber 30 are advantageously configured to cooperatively define a transfer-path 36 that fluidicly couples the lower-outlet 34 to the upper-inlet 26 such that the flowing-coolant 14 flows series-wise from the lower-chamber 30 into the upper-chamber 24. As used herein, the term 'series-wise' means that the same sampling of the flowing-coolant 14 that flows through the lower-chamber 30 will eventually flow through the upper-chamber 24, and that the volume flow-rate of the flowing-coolant 14 that flows through the lower-chamber 30 equals the volume flow-rate of the flowing-coolant 14 that flows through the upper-chamber 24. It is noted that the flowing-coolant 14 in the lower-chamber 30 flows in a direction that is generally characterized as parallel to, but in the opposite direction of the flowing-coolant 14 in the upper-chamber 24. The assembly may include a transfer-seal 38 configured to seal the transfer-path 36. The transfer-seal 38 may be formed of, for example, a silicon-rubber compound.

The upper-chamber 24 and the lower-chamber 30 are further advantageously configured to cooperatively define a manifold-connection 40 operable to couple the assembly 10 to a manifold-outlet 42 and a manifold-inlet 44 of the coolant-manifold 12 such that the flowing-coolant 14 flows through the assembly 10. The assembly 10, or more specifically the manifold-connection 40, includes a fitting 46, and may include a fitting-seal 52 formed of the same material used to form the transfer-seal 38.

Fig. 4 illustrates some non-limiting details of one embodiment of the fitting 46. The fitting 46 is generally configured to define an inlet-port 48 of the assembly 10 that directs the flowing-coolant 14 from the manifold-outlet 42 to the lower-inlet 32, and an outlet-port 50 that directs the flowing-coolant 14 from the upper-outlet 28 to the manifold-inlet 44. The inlet-port 48 and the outlet-port 50 are characterized as adjacent and side-by-side ports that are segregated from each other by a wall-section 54. That is, the flowing-coolant 14 in the inlet-port 48 is beside the flowing-coolant 14 in the outlet-port 50. More specifically, the inlet-port 48 and the outlet-port 50 do not have a coaxial relationship. A coaxial design was contemplated where the inlet and the outlet to the manifold consisted of a central circular opening and surrounded by a ring-shaped. The central opening allows fluid to bypass the bottom heat sink and flow directly to the top heat sink. However, these coaxial openings resulted in an undesirable packaging height. The problem associated with the height of the coaxial design combined with the desire for fluid to flow on two different planes was solved by the side-by-side configuration of the manifold-connection described herein.

In the embodiment of the fitting 46 shown in Fig. 4, the fitting 46 is further configured to define an extended-portion 56 that further defines the outlet-port 50 between the upper-chamber 24 and the coolant-manifold 12 that passes through a portion of the lower-chamber 30.

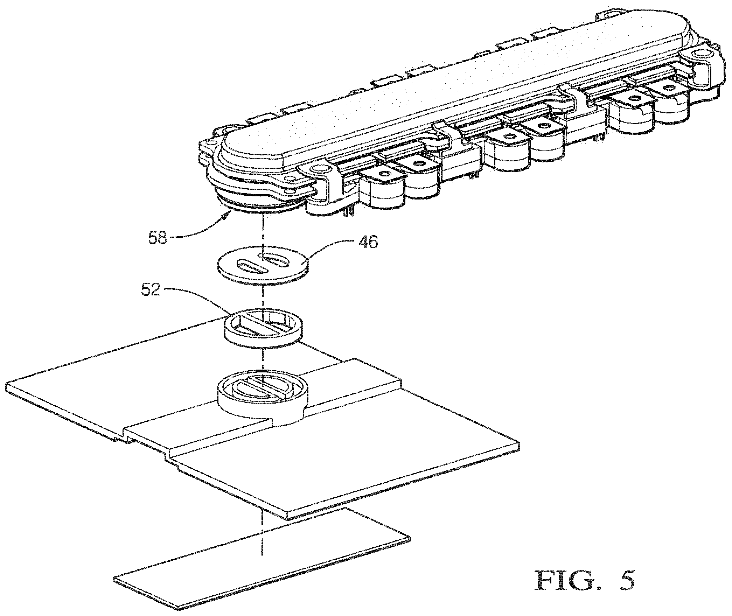

Fig. 5 shows an alternative embodiment of the fitting 46 that does not include the extended-portion 56. In this example, the lower-chamber 30 is further configured to define a via-portion 58. While the via-portion 58 is not specifically shown, it is understood to have a shape similar to the extended-portion 56 and cooperates with the flat embodiment of the fitting 46 shown in Fig. 5 to define a pathway similar to the outlet-port 50 between the upper-chamber 24 and the coolant-manifold 12 though the body of the lower-chamber 30.

Accordingly, a fluid-cooled electronics assembly for high-power electronics (the assembly 10) is provided. The problems with the coaxial design are solved through the use of a flat coplanar spout fitting. The new design features a novel flat interface with two openings or ports in a side-by-side configuration, one of which bypasses the lower-chamber 30. These two openings are separated to allow for a seal or gasket, and friction-stir weld-path to be placed between the two openings, thereby eliminating the need for a tall spout and complex coolant-manifold. This design elegantly separates the inlet and outlet fluid in a simple low profile fitting. The coplanar design differs from the coaxial design in that all the openings are on one plane and that the inlet and outlet ports are not concentric. The advantages of these changes are the low profile fitting and a simple inlet and outlet design.

While this invention has been described in terms of the preferred embodiments thereof, it is not intended to be so limited, but rather only to the extent set forth in the claims that follow.

## Claims

1. A fluid-cooled electronics assembly (10) for high-power electronics, said assembly (10) comprising:
an arrangement (16) of electronic components that defines an upper-side (18) of the arrangement (16) and a lower-side (20) of the arrangement (16) opposite the upper-side (18);
an upper-chamber (24) thermally coupled to the upper-side (18), said upper-chamber (24) configured to guide flowing-coolant (14) from an upper-inlet (26) to an upper-outlet (28) to remove heat from the upper-side (18);
a lower-chamber (30) thermally coupled to the lower-side (20), said lower-chamber (30) configured to guide flowing-coolant (14) from a lower-inlet (32) to a lower-outlet (34) to remove heat from the lower-side (20),
wherein the upper-chamber (24) and the lower-chamber (30) are further configured to cooperatively define a transfer-path (36) that fluidicly couples the lower-outlet (34) to the upper-inlet (26) such that the flowing-coolant (14) flows series-wise from the lower-chamber (30) into the upper-chamber (24),
**characterized in that** the upper-chamber (24) and the lower-chamber (30) are further configured to cooperatively define a manifold-connection (40) operable to couple the assembly (10) to a manifold-outlet (42) and a manifold-inlet (44) of a coolant-manifold (12) such that the flowing-coolant (14) flows through the assembly (10); the manifold-connection (40) including
a fitting (46) configured to define an inlet-port (48) of the assembly (10) that directs the flowing-coolant (14) from the manifold-outlet (42) to the lower-inlet (32), and an outlet-port (50) that directs the flowing-coolant (14) from the upper-outlet (28) to the manifold-inlet (44), wherein the inlet-port (48) and the outlet-port (50) are characterized as adjacent and side-by-side ports that are segregated from each other by a wall-section (54).

2. The assembly (10) in accordance with claim 1, wherein the fitting (46) is further configured to define an extended-portion (56) that defines the outlet-port (50) between the upper-chamber (24) and the coolant-manifold (12) though the lower-chamber (30).

3. The assembly (10) in accordance with claim 1 or 2, wherein the lower-chamber (30) is further configured to define a via-portion (58) that defines the outlet-port (50) between the upper-chamber (24) and the coolant-manifold (12) though the lower-chamber (30).

## Patentansprüche

1. Fluid-gekühlte Elektronikbaugruppe (10) für Hochleistungselektronik, wobei die Baugruppe (10) aufweist:
eine Anordnung (16) von elektronischen Komponenten, die eine Oberseite (18) der Anordnung (16) und eine Unterseite (20) der Anordnung (16) gegenüber der Oberseite (18) definiert;
eine obere Kammer (24), die mit der Oberseite (18) thermisch gekoppelt ist, wobei die obere Kammer (24) konfiguriert ist, ein fließendes Kühlmittel (14) von einem oberen Einlass (26) zu einem oberen Auslass (28) zu leiten, um Wärme von der Oberseite (18) abzuführen;
eine untere Kammer (30), die mit der Unterseite (20) thermisch gekoppelt ist, wobei die untere Kammer (30) konfiguriert ist, ein fließendes Kühlmittel (14) von einem unteren Einlass (32) zu einem unteren Auslass (34) zu leiten, um Wärme von der Unterseite (20) abzuführen,
wobei die obere Kammer (24) und die untere Kammer (30) weiter konfiguriert sind zum zusammenwirkenden Definieren eines Übertragungspfads (36), der den unteren Auslass (34) fluidmäßig mit dem oberen Einlass (26) koppelt derart, dass das fließende Kühlmittel (14) serienmäßig von der unteren Kammer (30) in die obere Kammer (24) fließt,
**dadurch gekennzeichnet, dass** die obere Kammer (24) und die untere Kammer (30) weiter konfiguriert sind zum zusammenwirkenden Definieren einer Verteilerverbindung (40), die betriebsfähig ist zum Koppeln der Baugruppe (10) mit einem Verteilerauslass (42) und einem Verteilereinlass (44) eines Kühlmittelverteilers (12) derart, dass das fließende Kühlmittel (14) durch die Baugruppe (10) fließt;
wobei die Verteilerverbindung (40) ein Anschlussstück (46) umfasst, das konfiguriert ist zum Definieren einer Einlassöffnung (48) der Baugruppe (10), die das fließende Kühlmittel (14) von dem Verteilerauslass (42) zu dem unteren Einlass (32) leitet, und einer Auslassöffnung (50), die das fließende Kühlmittel (14) von dem oberen Auslass (28) zu dem Verteilereinlass (44) leitet, wobei die Einlassöffnung (48) und die Auslassöffnung (50) als angrenzende und nebeneinander liegende Öffnungen gekennzeichnet sind, die durch einen Wandabschnitt (54) voneinander getrennt sind.

2. Die Baugruppe (10) gemäß Anspruch 1, wobei das Anschlussstück (46) weiter konfiguriert ist zum Definieren eines verlängerten Teils (56), der die Auslassöffnung (50) zwischen der oberen Kammer (24) und dem Kühlmittelverteiler (12) durch die untere Kammer (30) definiert.

3. Die Baugruppe (10) gemäß Anspruch 1 oder 2, wobei die untere Kammer (30) weiter konfiguriert ist zum Definieren eines Durchgangsteils (58), der die Auslassöffnung (50) zwischen der oberen Kammer (24) und dem Kühlmittelverteiler (12) durch die untere Kammer (30) definiert.

## Revendications

1. Ensemble électronique refroidi par fluide (10) pour système électronique à haute puissance, ledit ensemble (10) comprenant :
un agencement (16) de composants électroniques qui définissent une face supérieure (18) de l'agencement (16) et une face inférieure (20) de l'agencement (16) opposée à la face supérieure (18) ;
une chambre supérieure (24) couplée thermiquement à la face supérieure (18), ladite chambre supérieure (24) étant configurée pour guider un réfrigérant en écoulement (14) depuis une entrée supérieure (26) jusqu'à une sortie supérieure (28) pour évacuer de la chaleur depuis la face supérieure (18);
une chambre inférieure (30) couplée thermiquement à la face inférieure (20), ladite chambre inférieure (30) étant configurée pour guider le réfrigérant en écoulement (14) depuis une entrée inférieure (32) jusqu'à une sortie inférieure (34) pour évacuer de la chaleur depuis la face inférieure (20),
dans lequel la chambre supérieure (24) et la chambre inférieure (30) sont en outre configurées pour définir en coopération un trajet de transfert (36) qui couple en termes fluidique la sortie inférieure (34) à l'entrée supérieure (26) de sorte que le réfrigérant en écoulement (14) s'écoule en série depuis la chambre inférieure (30) jusque dans la chambre supérieure (24),
**caractérisé en ce que**
la chambre supérieure (24) et la chambre inférieure (30) sont en outre configurées pour définir en coopération une connexion de collecteur (40) dont la fonction est de coupler l'ensemble (10) à une sortie de collecteur (42) et à une entrée de collecteur (44) d'un collecteur de réfrigérant (12) de sorte que le réfrigérant en écoulement (14) s'écoule à travers l'ensemble (10) ; la connexion de collecteur (40) incluant un raccord (46) configuré pour définir un orifice d'entrée (48) de l'ensemble (10) qui dirige le réfrigérant en écoulement (14) depuis la sortie de collecteur (42) vers l'entrée inférieure (32), et un orifice de sortie (50) qui dirige le réfrigérant en écoulement (14) depuis la sortie supérieure (28) vers l'entrée de collecteur (44), dans lequel l'orifice d'entrée (48) et l'orifice de sortie (50) sont caractérisés comme étant des orifices adjacents et côte à côte qui sont séparés l'un de l'autre par une section de paroi (54).

2. Ensemble (10) selon la revendication 1, dans lequel le raccord (46) est en outre configuré pour définir une portion en extension (56) qui définit l'orifice de sortie (50) entre la chambre supérieure (24) et le collecteur de réfrigérant (12) à travers la chambre inférieure (30).

3. Ensemble (10) selon la revendication 1 ou 2, dans lequel la chambre inférieure (30) est en outre configurée pour définir une portion traversante qui définit l'orifice de sortie (50) entre la chambre supérieure (24) et le collecteur de réfrigérant (12) à travers la chambre inférieure (30).
